# EUROPÄISCHE PATENTANMELDUNG

(11) **EP 4 462 432 A1**
(43) Veröffentlichungstag der Anmeldung: **13.11.2024**
(21) Anmeldenummer: 24159679.0
(22) Anmeldetag: 26.02.2024
(51) Int. Cl.: G11C 8/08, G11C 13/00

(54) **SCHALTKREIS FÜR EIN EINSTELLEN EINES MEMRISTORS**

(30) Priorität: 12.05.2023 DE 102023204436
(71) Anmelder: Forschungszentrum Jülich GmbH, 52425 Jülich (DE)
(72) Erfinder: GREWING, Christian, 52428 Jülich (DE)
(74) Vertreter: Gille Hrabal Partnerschaftsgesellschaft mbB Patentanwälte

(57) **Zusammenfassung**

Die Erfindung betrifft einen Schaltkreis mit einem Analog-Digital-Wandler (1), einem Operationsverstärker (2), einem Memristor (3) und einem Transistor (4), wobei der Ausgang des Analog-Digital-Wandlers (1) mit dem einen ersten Eingang des Operationsverstärkers (2) elektrisch leitend verbunden ist und der Drain-Anschluss des Transistors (4) sowie ein erster elektrischer Anschluss des Memristors (4) mit dem anderen zweiten Eingang des Operationsverstärkers (2) elektrisch leitend verbunden sind und wobei der Ausgang des Operationsverstärkers (2) mit dem Gate-Anschluss des Transistors (4) elektrisch leitend verbunden ist.

Durch den Schaltkreis kann eine gewünschte Spannung sehr genau an den Memristor (3) angelegt werden. Der Schaltkreis kann für Rechenoperationen genutzt werden.

## Beschreibung

Die Erfindung betrifft einen Schaltkreis mit einem Memristor.

Ein Memristor ist ein elektrischer Widerstand mit zwei Anschlüssen. Der elektrische Widerstand hängt von der elektrischen Ladung ab, die durch den Widerstand hindurchfließt. Die Größe des elektrischen Widerstands kann außerdem von der Richtung des elektrischen Stroms abhängen und in Abhängigkeit von der Richtung größer oder kleiner werden.

Es kann von Interesse sein, den elektrischen Widerstand eines Memristors sehr genau einstellen zu können, so zum Beispiel mithilfe eines digitalen Signals, das durch einen Digital-Analog-Wandler in eine elektrische Spannung umgewandelt wird.

Ein Schaltkreis mit einem Memristor kann zusätzlich einen Digital-Analog-Wandler und einen Transistor aufweisen. Der Schaltkreis kann so beschaffen sein, dass eine vom Digital-Analog-Wandler ausgegebene Spannung durch den Transistor mit einem Wert des Memristors multipliziert wird. Der Ausgang des Digital-Analog-Wandlers kann mit dem Gate-Anschluss des Transistors verbunden sein. Der Memristor kann mit dem Source-Anschluss des Transistors verbunden sein. Über den Drain-Anschluss des Transistors kann das Ergebnis der Multiplikation ausgelesen werden. Ein solcher Schaltkreis kann für Berechnungen genutzt werden.

Ein derart einfach aufgebauter Schaltkreis kann starken Schwankungen unterliegen, so zum Beispiel aufgrund von Temperaturänderungen. Auch kann das Ergebnis eines so aufgebauten Schaltkreises sich von dem Ergebnis eines gleich aufgebauten Schaltkreises unterscheiden, weil die Bauelemente der beiden Schaltkreise nur gleich und nicht identisch sind.

Durch die Erfindung soll ein Schaltkreis mit Memristor mit verbesserten Eigenschaften bereitgestellt werden.

Vor diesem Hintergrund betrifft die Erfindung einen Schaltkreis. Der Schaltkreis kann eine Referenzspannungsquelle umfassen. Der Schaltkreis kann einen Operationsverstärker umfassen. Der Schaltkreis kann einen Memristor umfassen. Der Schaltkreis kann einen Transistor umfassen. Der Ausgang des Operationsverstärkers kann so mit dem Transistor verbunden sein, dass durch den Operationsverstärker der elektrische Widerstand des Transistors gesteuert wird. Die Eingänge des Operationsverstärkers können so mit der Referenzspannungsquelle und dem Transistor verbunden sein, dass der Operationsverstärker eine Spannungsdifferenz zwischen einer durch den Transistor bereitgestellten Spannung und der durch die Referenzspannungsquelle bereitgestellte Spannung verstärkt. Der Memristor kann so mit dem Transistor verbunden sein, dass die vom Transistor bereitgestellte Spannung am Memristor abfällt. Die Referenzspannungsquelle, der Operationsverstärker, der Transistor und der Memristor können so miteinander verschaltet sein, dass die von der Referenzspannungsquelle bereitgestellte elektrische Spannung mit der elektrischen Spannung übereinstimmt, die am Memristor abfällt und zwar unabhängig von externen Einflüssen wie Wärme oder Abweichungen aufgrund von eingesetzten Bauelementen.

Ein elektrischer Widerstand des Memristors kann daher sehr genau eingestellt werden. Es kann ein Wert des Memristors mit der Spannung, die durch die Referenzspannungsquelle bereitgestellt wird, multipliziert werden. Der Schaltkreis ermöglicht genaue Berechnungen.

Durch die Referenzspannungsquelle wird eine beispielsweise auf Masse bezogene elektrische Spannung bereitgestellt. Die Spannung hängt nicht oder praktisch nicht von der Stromstärke ab, welche der Referenzspannungsquelle entnommen wird.

Der Operationsverstärker hat zwei Eingänge. Der Operationsverstärker verstärkt eine Spannungsdifferenz zwischen seinen Eingängen. Die verstärkte Spannung wird über den Ausgang des Operationsverstärkers ausgegeben.

Der Transistor ist ein strom- oder spannungsgesteuerter elektrischer Widerstand. Der elektrische Widerstand des Transistors kann durch Anlegen einer elektrischen Spannung oder durch einen Stromfluss verändert werden.

Die elektrische Spannung der Referenzspannungsquelle ist vorzugsweise einstellbar. Es können also verschiedene Spannungen durch die Referenzspannungsquelle bereitgestellt werden.

Die Referenzspannungsquelle ist vorzugsweise ein Digital-Analog-Wandler. Der Digital-Analog-Wandler kann ein digitales Signal in ein analoges Signal umsetzen. Durch den Digital-Analog-Wandler kann die Spannung der Referenzspannungsquelle durch ein digitales Signal eingestellt werden. Ein solcher Schaltkreis vereinfacht seine Verwendung.

Der Transistor kann ein Feldeffekttransistor sein. Ein Feldeffekttransistor hat drei Anschlüsse, die Source-Anschluss, Drain-Anschluss und Gate-Anschluss genannt werden. Der elektrische Widerstand eines Feldeffekttransistors kann durch Anlegen einer Spannung an den Gate-Anschluss gesteuert werden.

Der Ausgang der Referenzspannungsquelle kann mit einem ersten Eingang des Operationsverstärkers elektrisch leitend verbunden sein. Der Drain-Anschluss des Transistors kann mit dem anderen zweiten Eingang des Operationsverstärkers elektrisch leitend sein. Ein erster elektrischer Anschluss des Memristors kann mit dem Drain-Anschluss des Transistors elektrisch leitend verbunden sein. Der Ausgang des Operationsverstärkers kann mit dem Gate-Anschluss des Transistors elektrisch leitend verbunden sein.

Der Transistor kann ein MOSFET sein, also ein Metall-Oxid-Halbleiter-Feldeffekttransistor. Der Gate-Anschluss eines MOSFETs besteht aus Metall, der vom Halbleiter durch eine Oxidschicht getrennt ist. Ein MOSFET hat einen Kanal, in dem sich Ladungsträger bewegen sollen, um den Source-Anschluss mit dem Drain-Anschluss elektrisch leitend zu verbinden. Der Kanal kann durch Anlegen einer Spannung an dem Gate-Anschluss verändert werden, um so den elektrischen Widerstand des Kanals zu verändern. Der Kanal verbindet eine dotierte Zone unterhalb des Source-Anschlusses mit einer dotierten Zone unterhalb des Drain-Anschlusses. Können durch den Kanal Elektronen fließen, dann handelt es sich um einen n-Kanal. Der Transistor wird dann NMOS genannt. Können durch den Kanal Löcher fließen, dann handelt es sich um einen p-Kanal. Der Transistor wird dann PMOS genannt. Beim NMOS ist das Grundsubstrat p-dotiert. Der entstehende Kanal ist ein n-Kanal. Beim PMOS ist das Grundsubstrat n-dotiert. Der entstehende Kanal ist ein p-Kanal.

Der Transistor ist vorzugsweise ein NMOS, um den technischen Aufwand besonders klein halten zu können. Wird ein NMOS eingesetzt, dann kann die gesamte Verstärkung geringgehalten werden und zwar insbesondere im Vergleich zu dem Fall, dass der Transistor ein PMOS ist. Der Schaltkreis kann dann besonders einfach stabil gehalten werden.

Der Drain-Anschluss des Feldeffekttransistors kann mit dem invertierenden Eingang des Operationsverstärkers verbunden sein. Dies gilt vor allem für den Fall, dass der Feldeffekttransistor ein NMOS ist. Ist der Feldeffekttransistor ein PMOS, dann kann der nichtinvertierende Eingang des Operationsverstärkers mit dem Drain - Anschluss des Feldeffekttransistors verbunden sein.

Der zweite Anschluss des Memristors kann in einer technisch einfachen Ausgestaltung mit Erde verbunden sein. "Verbunden sein" schließt nicht aus, dass ein Verbinden durch einen Schalter erfolgt und die Verbindung folglich durch Öffnen des Schalters getrennt werden kann.

Der Schaltkreis kann einen weiteren Memristor und einen weiteren Transistor umfassen. Der Ausgang des Operationsverstärkers kann mit dem Gate-Anschluss des weiteren Transistors elektrisch verbunden sein. Der Drain-Anschluss des weiteren Transistors kann mit dem einem Eingang des Operationsverstärkers verbunden sein. Ein erster elektrischer Anschluss des weiteren Memristors kann elektrisch mit dem Drain - Anschluss des weiteren Transistors verbunden sein. Es können mit geringem technischen Aufwand Multiplikationen parallel ausgeführt werden.

Der Schaltkreis kann eine weitere Referenzspannungsquelle, einen weiteren Operationsverstärker, einen weiteren Memristor und einen weiteren Transistor umfassen. Die Eingänge des weiteren Operationsverstärkers können so mit der weiteren Referenzspannungsquelle und dem weiteren Transistor verbunden sein, dass der weitere Operationsverstärker eine Spannungsdifferenz zwischen einer durch den weiteren Transistor bereitgestellten Spannung und einer durch die weitere Referenzspannungsquelle bereitgestellte Spannung verstärken kann. Der Ausgang des weiteren Operationsverstärkers kann so mit dem weiteren Transistor verbunden sein, dass durch den weiteren Operationsverstärker der elektrische Widerstand des weiteren Transistors gesteuert werden kann. Ein erster Anschluss des weiteren Memristors kann so mit dem weiteren Transistor verbunden sein, dass die vom weiteren Transistor bereitgestellte Spannung am weiteren Memristor abfällt. Eine Ausleseeinrichtung kann vorhanden sein, mit der ein Strom ausgelesen werden kann, der durch den Transistor und den weiteren Transistor fließt. Es können mit dieser Ausgestaltung Additionsaufgaben effizient durchgeführt werden.

Zwei Memristoren des Schaltkreises können in einer ersten Ebene angeordnet sein. Zwei Transistoren können in einer anderen Ebene oberhalb der ersten Ebene angeordnet sein. Die Transistoren können seitlich versetzt von den Memristoren angeordnet sein. Diese Anordnung kann den Verdrahtungsaufwand geringhalten.

Die Referenzspannungsquelle und der Operationsverstärker können unterhalb oder oberhalb der beiden Ebenen angeordnet sein, um den Verdrahtungsaufwand gering zu halten.

Es kann eine Reset - Einrichtung für den Memristor vorhanden sein, die so eingerichtet ist, dass ein elektrischer Strom durch den Memristor in Reset - Richtung hindurchfließen kann. Fließt der Strom in Reset - Richtung, so wird dadurch der Memristor zurückgesetzt. Während des planmäßigen Betriebs fließt der Strom in einer ersten Richtung durch den Transistor. In einer dazu umgekehrten Richtung fließt der Strom in Reset - Richtung.

Die Reset - Einrichtung kann einen Transistor umfassen, der mit dem zweiten Anschluss des Memristors verbunden ist und mit Erde über einen Schalter verbindbar ist. Es kann eine Einrichtung vorhanden sein, über den der Transistor der Reset - Einrichtung niederohmig geschaltet werden kann. Der Transistor der Reset - Einrichtung kann über einen Schalter so mit dem Ausgang des Operationsverstärkers verbindbar sein, dass ein Strom in Reset - Richtung durch den Memristor fließen kann.

Der Transistor kann über einen Schalter mit Erde verbindbar sein. Eine Einrichtung kann vorhanden sein, mit der Transistor niederohmig geschaltet werden kann. Dies erleichtert es, mit geringem technischen Aufwand den Memristor zurücksetzen zu können.

An den Memristor kann sowohl eine positive Spannung als auch eine negative Spannung angelegt werden.

Nachfolgend wird die Erfindung anhand von Figuren beispielhaft näher erläutert.

Es zeigen:
Figur 1: Schaltkreis;
Figur 2: Schaltkreises mit spaltenweiser Erweiterung;
Figur 3: Schaltkreises mit zeilenweiser Erweiterung;
Figur 4: Schaltkreis mit Reset - Einrichtung;
Figur 5: Einrichtung für ein Auslesen.

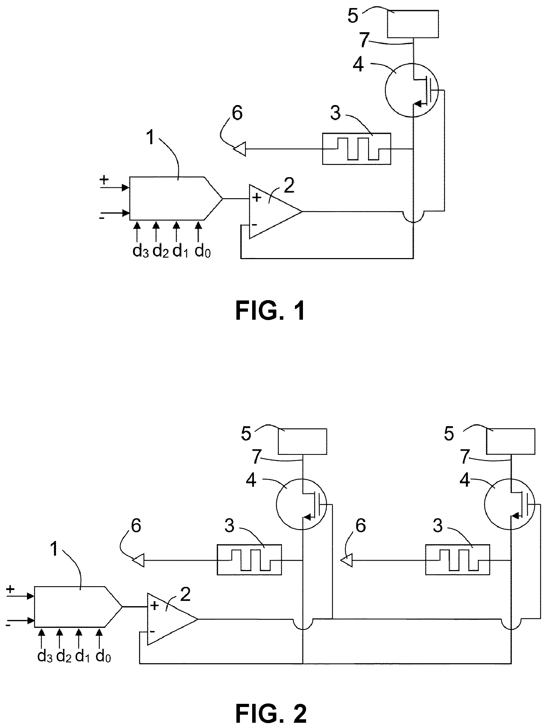

In der Figur 1 wird ein Ausführungsbeispiel einer Schaltung mit einem Digital-Analog-Wandler 1, einem Operationsverstärker 2, einem Memristor 3 und einem Transistor 4 gezeigt. Der Transistor 4 ist vorzugsweise ein MOSFET-Transistor. Der Transistor 4 ist besonders bevorzugt ein NMOS. Der Ausgang des Digital-Analog-Wandlers 1 ist über eine elektrische Leiterbahn mit dem einen ersten "+" - Eingang des Operationsverstärkers 2 verbunden und zwar insbesondere dann, wenn der Transistor 4 ein NMOS ist. Der andere zweite "-" - Eingang des Operationsverstärkers 2 ist über eine elektrische Leiterbahn mit einem ersten Anschluss des Memristors 3 verbunden und zwar insbesondere dann, wenn der Transistor 4 ein NMOS ist. Der invertierende Eingang wird durch "-" dargestellt. Der nichtinvertierende Eingang wird durch "+" dargestellt. Der Ausgang des Operationsverstärkers 2 ist über eine elektrische Leiterbahn mit dem Gate-Anschluss des Transistors 4 verbunden. Der Drain-Anschluss des Transistors 4 ist über eine elektrische Leiterbahn mit dem "-" - Eingang des Operationsverstärkers 2 und daher auch mit einem ersten elektrischen Anschluss des Memristors 3 verbunden. Der Source-Anschluss des Transistors 4 kann über eine elektrische Leiterbahn an eine Einrichtung 5 angeschlossen sein. Durch die Einrichtung 5 kann der elektrische Strom zur Verfügung gestellt werden, der während des Betriebs benötigt wird. Der zweite elektrische Anschluss des Memristors 3 ist über eine elektrische Leiterbahn mit Erde 6 verbunden.

Über d0 bis d1 kann ein digitales Signal an den Digital-Analog-Wandler 1 übermittelt werden. Der Digital-Analog-Wandler 1 wandelt das digitale Signal in ein analoges Spannungssignal um. Dieses analoge Spannungssignal versorgt den "+" - Eingang des Operationsverstärkers 2 während des Betriebs mit einer elektrischen Spannung. Der Drain-Anschluss des Transistors 4 versorgt den anderen "-" - Eingang des Operationsverstärkers 2 während des Betriebs mit einer elektrischen Spannung. Der Operationsverstärker verstärkt die Differenz zwischen den beiden Eingangsspannungen und versorgt so den Gate-Anschluss des Transistors 4 mit einer elektrischen Spannung. Über die am Gate-Anschluss des Transistors 4 anliegende Spannung wird der elektrische Widerstand des Transistors 4 geregelt und damit auch die Spannung, die über den Memristor abfällt und die am "-" - Eingang des Operationsverstärkers 2 während des Betriebs anliegt. Durch diese Rückkopplung wird erreicht, dass die Spannungsdifferenz zwischen den beiden Eingängen des Operationsverstärkers auf null geregelt wird. Die Ausgangsspannung des Digital-Analogwandlers ist dann gleich der Spannung, die am Memristor 3 abfällt. Es kann das dadurch entstandene elektrische Signal am Drain-Anschluss des Transistors 4 über eine Leiterbahn 7 ausgelesen werden.

Die Einrichtung 5 kann einen Bias - Punkt umfassen, der den Strom zur Verfügung stellt. Die Einrichtung 5 kann so eingerichtet sein, dass diese einen fließenden Strom auslesen kann. Es kann ein Analog - Digital - Wandler vorhanden sein, der den ausgelesenen Strom digitalisiert. Das digitalisierte Stromsignal kann dann digital weiterverarbeitet werden. Der fließende Strom wird durch den Strom bestimmt, der während des Betriebs durch den Memristor 3 hindurchfließt.

Durch den in der Figur 1 gezeigten Schaltkreis kann die Spannung, die am Memristor 3 abfällt, sehr genau eingestellt werden. Durch die Verwendung einer Source-Folge-Transistorschaltung als aktives Element kann der Strom am Memristor 3 leicht erfasst werden. Der Schaltkreis kann für sogenannte "tile operation" wie Vektormultiplikation in der Speicherberechnung verwendet werden. Der Schaltkreis kann Teil einer Matrixstruktur sein, ohne dafür einen großen Verdrahtungsaufwand betreiben zu müssen.

Die Figur 2 verdeutlicht, dass ohne großen Verdrahtungsaufwand eine spaltenweise Erweiterung möglich ist. Der Schaltkreis umfasst wie in der Figur 1 einen Digital-Analog-Wandler 1 und einen Operationsverstärker 2. Im Unterschied zu dem Schaltkreis aus der Figur 1 sind zwei Memristoren und zwei Transistoren vorhanden. Der Ausgang des Digital-Analog-Wandlers 1 ist wie im Fall der Figur 1 über eine elektrische Leiterbahn mit dem einen ersten "+" - Eingang des Operationsverstärkers 2 verbunden. Der andere zweite "-" - Eingang des Operationsverstärkers 2 ist elektrisch mit einem ersten Anschluss der zwei Memristoren 3 verbunden. Der Ausgang des Operationsverstärkers 2 ist mit einem jeden Gate-Anschluss der beiden Transistoren 4 elektrisch verbunden. Ein jeder Drain-Anschluss der beiden Transistoren 4 ist dem "-" - Eingang des Operationsverstärkers 2 und mit dem zugehörigen ersten elektrischen Anschluss eines jeden Memristors 3 elektrisch verbunden. Der Source-Anschluss eines jeden Transistors 4 ist an eine Einrichtung 5 angeschlossen. Der zweite elektrische Anschluss eines jeden Memristors 3 ist geerdet.

Um den Verdrahtungsaufwand gering halten zu können, können der Digital-Analog-Wandler 1 und der Operationsverstärker 2, wie in der Figur 2 gezeigt, hintereinander angeordnet sein. Die Memristoren 3 können, wie in der Figur 2 gezeigt, in einer ersten Ebene oberhalb von Digital-Analog-Wandler 1 und Operationsverstärker 2 angeordnet sein. Die Transistoren 4 können in einer zweiten Ebene, wie in der Figur 2 gezeigt, oberhalb der Memristoren 3 angeordnet sein. Die Transistoren 4 können, wie in der Figur 2 gezeigt, seitlich versetzt von den Memristoren 3 angeordnet sein. Eine solche Anordnung ermöglicht eine spaltenweise Anordnung von zusätzlichen Memristoren 3 und zusätzlichen Transistoren 4 mit geringem Verdrahtungsaufwand. Es können weitere Spalten hinzugefügt werden, die jeweils einen Memristor 3 und einer Transistor 4 hinzufügen.

Jede Spalte kann eine Einrichtung 8 für ein Auslesen umfassen, um das erzeugte Signal in digitalisierter Form weiter verarbeiten zu können. Die Einrichtungen 8 können in einer anderen, dritten Ebene angeordnet sein, die sich beispielsweise, wie in der Figur 2 gezeigt, oberhalb der Transistoren 4 befinden kann. Die dritte Ebene kann sich aber auch beispielsweise am unteren Rand des Schaltkreises befinden, also beispielsweise unterhalb von Digital-Analog-Wandler 1 und der Operationsverstärker 2.

Mit einem solchen Schaltkreis können Multiplikationen parallel durchgeführt und ausgelesen werden.

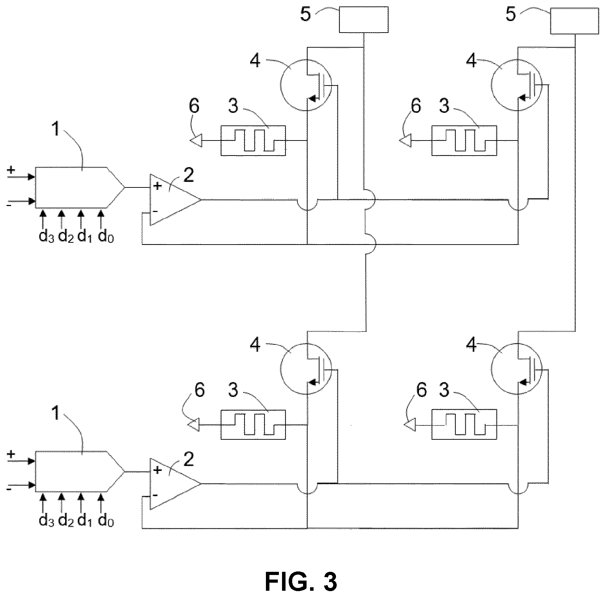

Die Figur 3 zeigt, dass den Spalten aus Figur 2 Zeilen für Additionsaufgaben hinzugefügt werden können, ohne dafür einen großen Verdrahtungsaufwand betreiben zu müssen. Eine jede Zeile ist so aufgebaut, wie dies in der Figur 2 gezeigt wird. Die Transistoren 4 einer Spalte, also die untereinander angeordneten Transistoren 4, sind aber jeweils nur mit einer Einrichtung 5 verbunden. Für jede Spalte kann nur eine Einrichtung 5 für ein Auslesen vorhanden sein. Es werden die elektrischen Ströme addiert und ausgelesen, die durch zwei untereinander angeordnete Transistoren 4 fließen. Der Strom, der durch einen Transistor fließt, ist das Ergebnis einer Multiplikation, die aus der Spannung eines Digital - Analog -Wandlers 1 und einem Wert eines Memristors 3 resultiert.

Es können mit dieser Matrixstruktur spaltenweise Rechenoperationen wie Vektormultiplikation und/oder Vektoraddition energieeffizient ausgeführt werden.

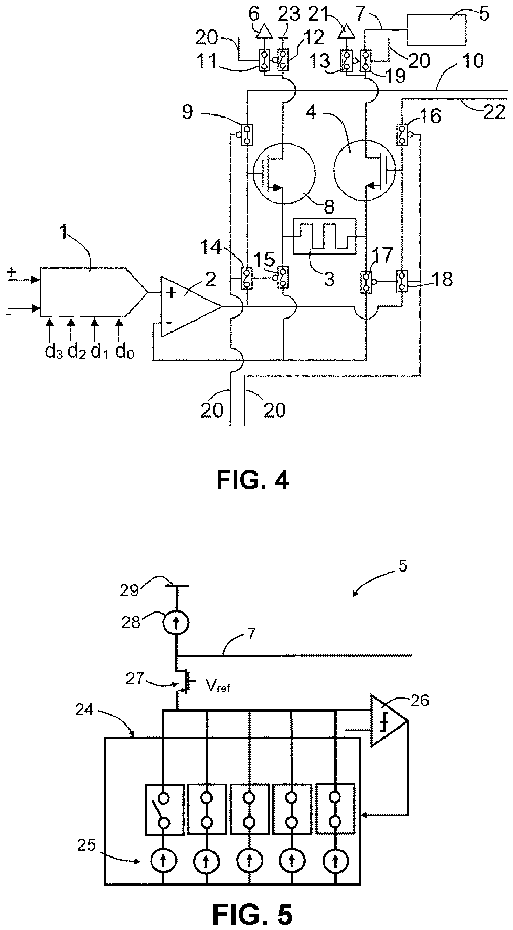

In der Figur 4 wird ein Schaltkreis gezeigt, der eine Reset - Einrichtung umfasst, mit der der Memristor 3 zurückgesetzt werden kann. Der zweite Ausgang des Memristors 3 ist mit dem Drain - Anschluss eines weiteren Transistors 8 verbunden. Ist der Schalter 9, wie in der Figur 4 gezeigt, geschlossen, dann wird der Transistor 8 über die Leiterbahn 10 niederohmig geschaltet. Es fließt dann der elektrische Strom durch den Memristor 3 und den Transistor 8 hindurch über den dann geschlossenen Schalter 11 zur Erde 6. Die Schalter 12, 13, 14, 15 und 16 sind dann geöffnet, wie dies in der Figur 4 gezeigt wird. Die Schalter 17, 18 und 19 sind dann geschlossen, wie dies in der Figur 4 gezeigt wird. Der in der Figur 4 gezeigte Schaltkreis arbeitet dann in gleicher Weise wie der in der Figur 1 gezeigte Schaltkreis. Für ein Zurücksetzen des Memristors 3 werden die Schalter 12, 13, 14, 15 und 16 geschlossen. Die Schalter 17, 18 und 19 werden geöffnet. Das Öffnen und Schließen der Schalter 12 bis 19 erfolgt über Leiterbahnen 20.

Durch das Schließen des Schalters 13 wird der Source - Anschluss des Transistors 4 mit der Erde 21 verbunden. Durch das Schließen des Schalters 16 wird der Gate - Anschluss des Transistors 4 mit der Leiterbahn 22 verbunden. Dadurch wird der Transistor 4 niederohmig geschaltet. Durch das Öffnen des Schalters 19 wird der Source - Anschluss des Transistors 4 von der Stromquelle getrennt. Durch das Öffnen des Schalters 18 wird der Gate - Anschluss des Transistors 4 von dem Ausgang des Operationsverstärkers 2 getrennt. Durch das Öffnen des Schalters 17 wird der Drain - Anschluss des Transistors 4 von dem - Ausgang des Operationsverstärkers 2 getrennt.

Durch das Öffnen des Schalters 11 wird der Source - Anschluss des weiteren Transistors 8 von der Erde 6 getrennt. Durch das Schließen des Schalters 12 wird der Source - Anschluss des weiteren Transistors 8 mit einer Stromquelle 23 verbunden. Durch das Öffnen des Schalters 9 wird der Gate - Anschluss des weiteren Transistors 8 von der Leiterbahn 10 getrennt. Dadurch wird die niederohmige Schaltung des weiteren Transistors 8 aufgehoben. Durch das Schließen des Schalters 14 wird der Gate - Anschluss des weiteren Transistors 8 mit dem Ausgang des Operationsverstärkers 2 verbunden. Durch das Schließen des Schalters 15 wird der Drain - Anschluss des weiteren Transistors 8 mit dem einen Eingang des Operationsverstärkers 2 verbunden.

Es kann nun ein Strom in umgekehrter Richtung durch den Memristor 3 fließen. Dadurch wird der Memristor 3 zurückgesetzt. Der ordnungsgemäße Betrieb des Schaltkreises kann durch ein solches Zurücksetzen verbessert sichergestellt werden.

Wie im Fall der Figur 1 ist nach wie vor eine Matrixstruktur möglich, ohne dafür einen großen Verdrahtungsaufwand betreiben zu müssen.

In der Figur 5 wird ein Beispiel für eine Einrichtung 5 gezeigt. Die Einrichtung 5 umfasst einen Analog-Digital-Wandler 24. Der Analog-Digital-Wandler 24 kann eine Track-and-Hold-Schaltung aufweisen, die sich zwischen einem Transistor 27 und dem Analog-Digital-Wandler 24 befinden kann. Die Einrichtung 5 kann Stromquellen 25 aufweisen, die binär gewichtet sein können (aufgrund SAR Algorithmus). Der Analog-Digital-Wandler 24 kann einen Komparator 26 aufweisen. Zunächst kann beispielsweise das MSB ("most signifkant bit") durch Schalten eines ersten Schalters 25 mithilfe des Komparators 26 ermittelt werden. Mithilfe eines geeignet ausgewählten zweiten Schalters 25 kann im Anschluss ein nächstes Bit mithilfe des Komparators ermittelt werden usw.. Die Einrichtung 5 kann den Transistor 27 aufweisen. Die Einrichtung 5 kann eine Stromquelle 28 aufweisen. Die Stromquelle 28 kann mit Erde 29 verbunden sein.

Für die Digitalisierung des Ausgangssignals kann ein konstant großer Strom in Richtung Erde 29 fließen, der aus dem Strom des Ausgangssignals und einem vom Analog-Digital-Wandler 24 kommenden Strom zusammengesetzt sein kann. Die Stromquelle 28 kann einen Transistor zur Einstellung eines konstant großen Stroms umfassen. Die Stromquelle 28 kann eine veränderbare Stromquelle sein, um den konstant großen Strom einstellen zu können. Der vom Analog-Digital-Wandler 24 kommende Strom kann durch den ersten Transistor 27 der Einrichtung 5 hindurchfließen. Der Drain-Anschluss des ersten Transistors 27 kann mit dem Eingang des Analog-Digital-Wandlers 24 verbunden sein. Der erste Transistor 27 kann ein PMOSFET sein. An dem Gate-Anschluss des Transistors 27 kann eine Referenzspannung V_{ref} anliegen.

Das Ausgangssignal wird über den elektrischen Leiter 7 in die Ausleseeinrichtung 5 eingespeist und digitalisiert.

## Patentansprüche

1. Schaltkreis mit einer Referenzspannungsquelle (1), einem Operationsverstärker (2), einem Memristor (3) und einem Transistor (4), wobei die Eingänge (+, -) des Operationsverstärkers (2) so mit der Referenzspannungsquelle (1) und dem Transistor (4) verbunden sind, dass der Operationsverstärker (2) eine Spannungsdifferenz zwischen einer durch den Transistor (4) bereitgestellten Spannung und einer durch die Referenzspannungsquelle (1) bereitgestellten Spannung verstärken kann, wobei der Ausgang des Operationsverstärkers (2) so mit dem Transistor (4) verbunden ist, dass durch den Operationsverstärker (2) der elektrische Widerstand des Transistors (4) gesteuert werden kann, wobei der Memristor (3) so mit dem Transistor (4) verbunden ist, dass die vom Transistor (4) bereitgestellte Spannung am Memristor (3) abfällt.

2. Schaltkreis nach dem vorhergehenden Anspruch, **dadurch gekennzeichnet, dass** die Spannung, die durch die Referenzspannungsquelle (1) bereitgestellt werden kann, einstellbar ist.

3. Schaltkreis nach dem vorhergehenden Anspruch, **dadurch gekennzeichnet, dass** die Referenzspannungsquelle (1) ein Digital-Analog-Wandler ist.

4. Schaltkreis nach einem der vorhergehenden Ansprüche, **dadurch gekennzeichnet, dass** der Transistor (4) ein Feldeffekttransistor (4) ist, wobei der Drain-Anschluss des Feldeffekttransistors (4) mit einem Eingang des Operationsverstärkers (2) elektrisch leitend verbunden ist und ein Anschluss des Memristors (3) mit dem Drain-Anschluss des Feldeffekttransistors (4) elektrisch leitend verbunden ist und der Ausgang des Operationsverstärkers (2) mit dem Gate-Anschluss des Feldeffekttransistors (4) elektrisch leitend verbunden ist.

5. Schaltkreis nach dem vorhergehenden Anspruch, **dadurch gekennzeichnet, dass** der Feldeffekttransistor (4) ein NMOS ist.

6. Schaltkreis nach dem vorhergehenden Anspruch, **dadurch gekennzeichnet, dass** der Drain-Anschluss des Feldeffekttransistors (4) mit dem invertierenden Eingang des Operationsverstärkers (2) verbunden ist.

7. Schaltkreis nach einem der vorhergehenden Ansprüche, **dadurch gekennzeichnet, dass** der zweite Anschluss des Memristors (3) mit Erde (6) verbunden ist oder durch einen Schalter (11) mit Erde (6) verbunden werden kann.

8. Schaltkreis nach einem der vorhergehenden Ansprüche, **dadurch gekennzeichnet, dass** ein weiterer Memristor (3) und ein weiterer Transistor (4) vorhanden sind, wobei der Ausgang des Operationsverstärkers (2) mit dem Gate-Anschluss des weiteren Transistors (4) elektrisch verbunden ist, der Drain-Anschluss des weiteren Transistors (4) mit dem einem Eingang des Operationsverstärkers (2) verbunden ist und ein erster elektrischer Anschluss des weiteren Memristors (3) elektrisch mit dem Drain - Anschluss des weiteren Transistors (4) verbunden ist.

9. Schaltkreis nach einem der vorhergehenden Ansprüche, **dadurch gekennzeichnet, dass** eine weitere Referenzspannungsquelle (1), ein weiterer Operationsverstärker (2), ein weiterer Memristor (3) und ein weiterer Transistor (4) vorhanden sind, wobei die Eingänge (+, -) des weiteren Operationsverstärkers (2) so mit der weiteren Referenzspannungsquelle (1) und dem weiteren Transistor (4) verbunden sind, dass der weitere Operationsverstärker (2) eine Spannungsdifferenz zwischen einer durch den weiteren Transistor (4) bereitgestellten Spannung und einer durch die weitere Referenzspannungsquelle (1) bereitgestellte Spannung verstärken kann, wobei der Ausgang des weiteren Operationsverstärkers (2) so mit dem weiteren Transistor (4) verbunden ist, dass durch den weiteren Operationsverstärker (2) der elektrische Widerstand des weiteren Transistors (4) gesteuert werden kann, wobei ein erster Anschluss des weiteren Memristors (3) so mit dem weiteren Transistor (4) verbunden ist, dass die vom weiteren Transistor (4) bereitgestellte Spannung am weiteren Memristor (3) abfällt, wobei eine Ausleseeinrichtung (5) vorhanden ist, mit der ein Strom ausgelesen werden kann, der durch den Transistors (4) und den weiteren Transistor (4) fließt.

10. Schaltkreis nach dem vorhergehenden Anspruch, **dadurch gekennzeichnet, dass** der Transistor ein Feldeffekttransistor ist und die Ausleseeinrichtung so eingerichtet ist, dass der Strom gemessen und damit ausgelesen wird, der vom Source - Anschluss zum Drain - Anschluss der Transistoren (4) fließt.

11. Schaltkreis nach einem der vorhergehenden Ansprüche, **dadurch gekennzeichnet, dass** zwei Memristoren (3) des Schaltkreises in einer ersten Ebene angeordnet sind, zwei Transistoren (4) in einer anderen Ebene oberhalb der ersten Ebene angeordnet sind und die Transistoren (4) seitlich versetzt von den Memristoren (3) angeordnet sind.

12. Schaltkreis nach dem vorhergehenden Anspruch, **dadurch gekennzeichnet, dass** die Referenzspannungsquelle (1) und der Operationsverstärker (2) unterhalb oder oberhalb der beiden Ebenen angeordnet sind.

13. Schaltkreis nach einem der vorhergehenden Ansprüche, **dadurch gekennzeichnet, dass** eine Reset - Einrichtung für den Memristor (3) vorhanden ist, die so eingerichtet ist, dass ein elektrischer Strom durch den Memristor in Reset - Richtung hindurchfließen kann.

14. Schaltkreis nach dem vorhergehenden Anspruch, **dadurch gekennzeichnet, dass** die Reset - Einrichtung einen Transistor (8) umfasst, der mit dem zweiten Anschluss des Memristors (3) verbunden ist und mit Erde (6) über einen Schalter (11) verbindbar ist, mit einer Einrichtung (9, 10), über den der Transistor (8) der Reset - Einrichtung niederohmig geschaltet werden kann, wobei der Transistor (8) der Reset - Einrichtung über einen Schalter (14) so mit dem Ausgang des Operationsverstärkers (2) verbindbar ist, dass ein Strom in Reset - Richtung durch den Memristor (3) fließen kann.

15. Schaltkreis nach dem vorhergehenden Anspruch, **dadurch gekennzeichnet, dass** der Transistor (4) über einen Schalter (13) mit Erde (21) verbindbar ist und eine Einrichtung (16, 22) vorhanden ist, mit der der Transistor (4) niederohmig geschaltet werden kann.
